# EUROPEAN PATENT SPECIFICATION

(11) **EP 3 637 483 B1**
(45) Date of publication and mention of the grant of the patent: **21.02.2024**
(21) Application number: 19198337.8
(22) Date of filing: 19.09.2019
(51) Int. Cl.: H10N 10/856, H10N 10/17

(54) **COMPOSITE THERMOELECTRIC MATERIAL**
THERMOELEKTRISCHES VERBUNDMATERIAL
MATÉRIAU THERMOÉLECTRIQUE COMPOSITE

(30) Priority: 11.10.2018 US 201816157964
(43) Date of publication of application: 15.04.2020
(73) Proprietor: Rolls-Royce Corporation, Indianapolis, IN 46225 (US); Rolls-Royce North American Technologies, Inc., Indianapolis, IN 46241 (US)
(72) Inventor: Costello, John, Indianapolis, IN 46231 (US); Skertic, Richard, Carmel, IN 46033 (US)
(74) Representative: Rolls-Royce plc

(56) References cited:
- JP-A- 2003 209 297
- JP-A- 2016 082 132
- US-A1- 2009 229 794
- US-A1- 2013 258 583
- US-A1- 2017 373 612

## Description

The disclosure relates to thermoelectric materials and electronics enclosures.

Electronics enclosures house electronic components. For example, an electronics enclosure may house an engine controller, such as a full authority digital engine controller (FADEC) for a gas turbine engine. The electronics enclosure defines a physical barrier around the electronic components and may protect the electronic components from physical damage. The document US 2017/373612 A discloses an engine component for a gas turbine engine, the engine component including a substrate that includes a composite fiber and defines a surface. An energy harvesting fiber is positioned within the substrate.

In some examples, the disclosure describes an electronics enclosure comprising a plurality of walls, wherein at least one wall of the plurality of walls comprises the fibrous thermoelectric material, the thermally and electrically conductive mesh, and the matrix material, a first layer comprising a fibrous thermoelectric material, wherein the first layer defines a plane; a second layer comprising a thermally and electrically conductive mesh electrically coupled to the fibrous thermoelectric material, wherein the second layer is parallel to the plane and configured to facilitate heat transfer between the second layer and the first layer in a direction parallel to the plane; and a matrix material in which the first layer comprising the fibrous thermoelectric material and the second layer comprising the thermally and electrically conductive mesh are embedded.

By incorporating the fibrous thermoelectric material in the electronics enclosure, the electronics enclosure may enable active cooling and/or heating of an internal volume of the electronics enclosure, electronics components within the electronics enclosure, or both. Incorporating the fibrous thermoelectric material may reduce weight compared to an electronics enclosure that includes separate enclosure and cooling systems. Further, the electronics enclosure including the fibrous thermoelectric material may provide a reliable thermal control system, as the system may in some examples include no moving parts such as fans.

The thermally and electrically conductive mesh may additionally provide electromagnetic interference (EMI) protection for electronic components enclosed in the internal volume of the electronics enclosure.

In some embodiments, the fibrous thermoelectric material includes a woven fabric including strands.

In some embodiments, the strands include a thermoelectric polymer.

In some embodiments, the thermoelectric polymer includes poly(3,4 ethylenedioxythiophene): poly(styrenesulfonate).

In some embodiments, the thermally and electrically conductive mesh is interwoven with the strands of the woven fabric.

In some embodiments, the thermally and electrically conductive mesh includes a metal or alloy.

In some embodiments, the thermally and electrically conductive mesh is a first thermally and electrically conductive mesh, further including a second thermally and electrically conductive mesh. The fibrous thermoelectric material is between the first thermally and electrically conductive mesh and the second thermally and electrically conductive mesh.

The walls of the electronics enclosure may be used to transfer heat from within the internal volume of the electronics enclosure to outside the electronics enclosure, or vice versa, to maintain a temperature within the electronics enclosure or of a component within the electronics enclosure within a range.

In some embodiments, at least one wall includes a plurality of layers of the fibrous thermoelectric material and a plurality of layers of the thermally and electrically conductive mesh. Respective layers of the fibrous thermoelectric material alternate with respective layers of the thermally and electrically conductive mesh.

By including a plurality of thermally and electrically conductive layers interleaved or alternating with respective fibrous thermoelectric material layers, a heat transfer capacity may be increased.

The thermally and electrically conductive layers may conduct heat to and/or from the fibrous thermoelectric material layer and may provide electrical connects to the fibrous thermoelectric material layer to enable the thermoelectric effect upon application of a current to the fibrous thermoelectric material layer. The fibrous thermoelectric material layer may act as a heat pump to cause heat to flow from one side of the fibrous thermoelectric material layer to the other.

In some embodiments, the electronics enclosure further includes a power connector electrically coupled to the fibrous thermoelectric material.

In some embodiments, the electronics enclosure further includes structural reinforcement material embedded in the matrix material.

In some examples, the disclosure describes a system including an electronics enclosure and an electronic component enclosed in an internal volume of the electronics enclosure. The enclosure includes a fibrous thermoelectric material; a thermally and electrically conductive mesh; and a matrix material in which the fibrous thermoelectric material and the thermally and electrically conductive mesh are embedded. The electronic component is thermally coupled to the electronics enclosure.

In some embodiments, the system further includes at least one heat pipe positioned to thermally couple the electronic component to the electronics enclosure.

In some embodiments, the electronic component is positioned in thermal contact with the electronics enclosure.

In some embodiments, the fibrous thermoelectric material includes a woven fabric including strands further including a thermoelectric polymer.

In some embodiments, the thermally and electrically conductive mesh is interwoven with the strands of the woven fabric.

In some embodiments, the thermally and electrically conductive mesh includes a metal or alloy.

In some embodiments, the thermally and electrically conductive mesh is a first thermally and electrically conductive mesh, further including a second thermally and electrically conductive mesh. The fibrous thermoelectric material is between the first thermally and electrically conductive mesh and the second thermally and electrically conductive mesh.

In some embodiments, the electronics enclosure includes at least one wall including a plurality of layers of the fibrous thermoelectric material and a plurality of layers of the thermally and electrically conductive mesh. Respective layers of the fibrous thermoelectric material alternate with respective layers of the thermally and electrically conductive mesh.

In some embodiments, the electronics enclosure further includes a power connector electrically coupled to the fibrous thermoelectric material.

In some embodiments, the electronics enclosure further includes structural reinforcement material embedded in the matrix material.

In some examples, the disclosure describes a composite thermoelectric material including a fibrous thermoelectric material; a thermally and electrically conductive mesh; a structural reinforcement material; and a matrix material in which the fibrous thermoelectric material, the thermally and electrically conductive mesh, and the structural reinforcement material are embedded.

The composite thermoelectric material may be used to cool and/or heat the internal volume of an electronics enclosure (e.g., air and other materials within the electronics enclosure) instead of or in addition to directly cooling an electronic component. For example, at least a portion of an internal surface of one or more walls of the electronic enclosure may be exposed to the internal volume of the electronics enclosure but may not be in contact with an electronic component or heat pipe. In this way, the electronics enclosure may directly cool and/or heat an electronic component by being thermally coupled to the electronic component, indirectly cool and/or heat an electronic component by cooling an atmosphere of the internal volume of the electronics enclosure, or both.

Further, the thermally and electrically conductive mesh may additionally provide EMI protection for electronic components in examples in which composite thermoelectric material is used to form an electronics enclosure.

The details of one or more examples are set forth in the accompanying drawings and the description below. Other features, objects, and advantages will be apparent from the description and drawings, and from the claims.
FIG. 1 is a conceptual diagram illustrating a composite thermoelectric material in accordance with the disclosure.
FIG. 2 is a conceptual diagram illustrating another composite thermoelectric material in accordance with the disclosure.
FIG. 3 is a conceptual diagram illustrating another composite thermoelectric material in accordance with the disclosure.
FIG. 4 is a conceptual diagram illustrating another composite thermoelectric material in accordance with the disclosure.
FIG. 5 is a conceptual and schematic diagram illustrating an example electrical system including an electronics enclosure that includes a composite thermoelectric material.
FIG. 6 is a conceptual diagram illustrating an example gas turbine engine that includes an electronics enclosure including a composite thermoelectric material.

The disclosure describes a composite thermoelectric material and electronics enclosures incorporating the composite thermoelectric material. The composite thermoelectric material may be in the form of a sheet and may include a fibrous thermoelectric material, a thermally and electrically conductive mesh, and a matrix material. The fibrous thermoelectric material and the thermally and electrically conductive mesh may be embedded in the matrix material. In some examples, the composite thermoelectric material also may include a structural reinforcement material, which also may be embedded in the matrix material. The thermally and electrically conductive mesh may be configured to conduct electrical current to the fibrous thermoelectric material to enable the thermoelectric effect. In some examples, the structural reinforcement material layers may be present on both sides of the sheet with the thermally and electrically conductive mesh and the fibrous thermoelectric material between the structural reinforcement material layers.

The composite thermoelectric material may be used as walls of an enclosure or chassis, such as an electronics enclosure. In this way, the one or more walls of the electronics enclosure may be used to transfer heat from within an internal volume of the electronics enclosure to outside the electronics enclosure, or vice versa, to maintain a temperature within the electronics enclosure or of a component within the electronics enclosure within a range.

The electronics enclosure may be used as part of a system in which an electronic component is enclosed within an internal volume of the electronics enclosure. In some examples, the electronic component is in thermal communication with the composite thermoelectric material. For example, the electronic component may be in thermal contact with the composite thermoelectric material directly or via a thermal interface material. As another example, a heat pipe may thermally couple the electronic component to the composite thermoelectric material.

Additionally, or alternatively, the composite thermoelectric material may be used to cool and/or heat the internal volume of the electronics enclosure (e.g., air and other materials within the electronics enclosure) instead of or in addition to directly cooling the electronic component. For example, at least a portion of an internal surface of one or more walls of the electronic enclosure may be exposed to the internal volume of the electronics enclosure but may not be in contact with an electronic component or heat pipe. In this way, the electronics enclosure may directly cool and/or heat an electronic component by being thermally coupled to the electronic component, indirectly cool and/or heat an electronic component by cooling an atmosphere of the internal volume of the electronics enclosure, or both.

By incorporating a fibrous thermoelectric material in an electronics enclosure, the electronics enclosure may enable active cooling and/or heating of an internal volume of the electronics enclosure, electronics components within the electronics enclosure, or both. Incorporating the fibrous thermoelectric material may reduce weight compared to an electronics enclosure that includes separate enclosure and cooling systems. Further, the electronics enclosure including the fibrous thermoelectric material may provide a reliable thermal control system, as the system may in some examples include no moving parts such as fans.

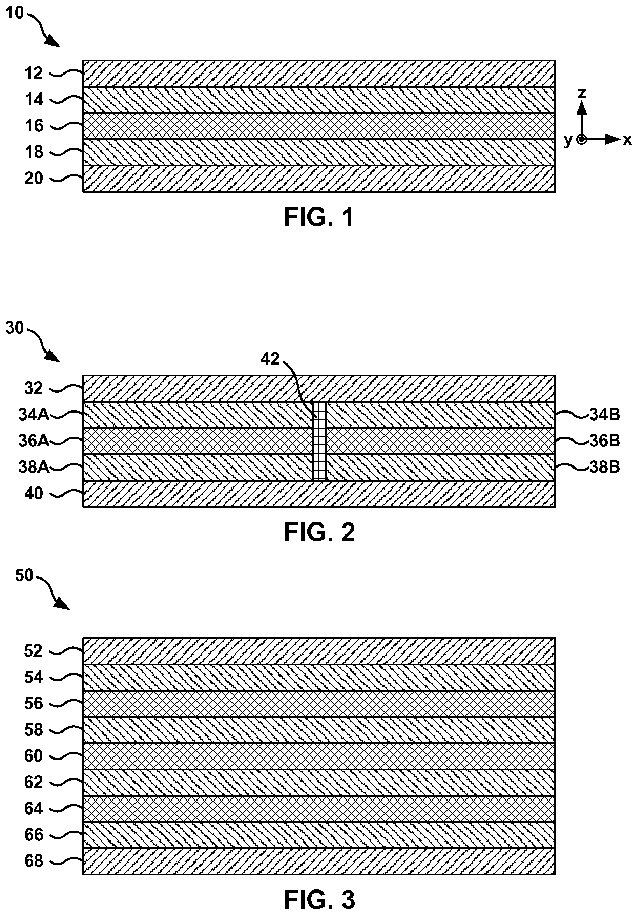

FIG. 1 is a conceptual diagram illustrating a composite thermoelectric material 10 in accordance with the disclosure. Composite thermoelectric material 10 includes a first structural reinforcement layer 12, a first thermally and electrically conductive layer 14, a fibrous thermoelectric material layer 16, a second thermally and electrically conductive layer 18, and a second structural reinforcement layer 20. In the example of FIG. 1, first and second structural reinforcement layers 12 and 20 define the outer surfaces of composite thermoelectric material 10, with first and second thermally and electrically conductive layers 14 and 18 between first and second structural reinforcement layers 12 and 20 and fibrous thermoelectric material layer 16 between first and second thermally and electrically conductive layers 14 and 18. In other examples, composite thermoelectric material 10 may include a single structural reinforcement layer, a single thermally and electrically conductive layer, or both. In other examples, a composite thermoelectric material may include additional layers, as described below with reference to FIGS. 2 and 3.

Structural reinforcement layers 12 and 20 may provide structural support to composite thermoelectric material 10. In some examples, one or both of structural reinforcement layers 12 and 20 may include composite materials. For example, structural reinforcement layers 12 and 20 may include fiber reinforced plastics. The fibers may include any suitable composition, such as glass, carbon, aramid, or the like. In some examples, the fibers are selected to have relatively high thermal conductivity to contribute to thermal conductivity of structural reinforcement layers 12 and 20. In some examples, the fibers may be continuous fibers arranged in unidirectional layers, woven or braided fabrics, or the like. In other examples, the fibers may be chopped, relatively short fibers arranged substantially randomly. In still other examples, the fibers may include both continuous fibers arranged in unidirectional layers, woven or braided fabrics, or the like and chopped, relatively short fibers arranged substantially randomly. Continuous fibers may contribute mechanical strength and stiffness along the length of the fiber, while chopped fibers may reduce the anisotropy of the mechanical and thermal properties of structural reinforcement layers 12 and 20 and improve thermal conductivity in the z-axis direction of FIG. 1 by having at least some fibers arranged with a long axis oriented out of the x-y plane of FIG. 1.

In examples in which one or both of structural reinforcement layers 12 and 20 include composite materials, the composite material also may include a matrix material in which the fibers are embedded. The matrix material may include a plastic, such as, for example, a polyester, an epoxy, a polyamide, a polycarbonate, a polypropylene, a vinyl ester, or the like.

In some examples, at least a portion of one or both of structural reinforcement layers 12 and 20 may include a highly thermally conductive non-composite material. For example, at least a portion of one or both of structural reinforcement layers 12 and 20 may include a metal or alloy, such as copper or a copper alloy, aluminum or an aluminum alloy, or the like. The highly thermally conductive non-composite material may facilitate heat transfer to first thermally and electrically conductive layer 14, second thermally and electrically conductive layer 18, or both at the location at which the highly thermally conductive non-composite material is located.

First and second thermally and electrically conductive layers 14 and 18 are located adjacent to and in contact with first and second structural reinforcement layers 12 and 20, respectively. First and second thermally and electrically conductive layers 14 and 18 are configured to facilitate heat transfer from first and second structural reinforcement layers 12 and 20 to fibrous thermoelectric material layer 16 and vice versa, and heat transfer parallel to the x-y plane of FIG. 1 (e.g., within the plane of first and second thermally and electrically conductive layers 14 and 18). One or both of first and second thermally and electrically conductive layers 14 and 18 are also configured to carry electrical current to fibrous thermoelectric material layer 16, which electrical current induces the thermoelectric effect in fibrous thermoelectric material layer 16. As such, first and second thermally and electrically conductive layers 14 and 18 include thermally and electrically conductive material, such as a metal, an alloy, carbon nanotubes, or combinations thereof. For example, first and second thermally and electrically conductive layers 14 and 18 may include copper or a copper alloy, aluminum or an aluminum alloy, another electrically conductive metal or alloy, or combinations thereof.

In some examples, first and second thermally and electrically conductive layers 14 and 18 may include thermally and electrically conductive wires or filaments in a matrix material. The thermally and electrically conductive wires or filaments may be arranged in any suitable configuration. In some examples, the thermally and electrically conductive wires or filaments may be disposed as a mesh, e.g., woven in a mesh. A mesh may additionally provide electromagnetic interference (EMI) protection for electronic components in examples in which composite thermoelectric material 10 is used to form an electronics enclosure.

The matrix material may be the same or different as the matrix material in first and second structural reinforcement layers 12 and 20. In some examples, the matrix material is continuous between first and second structural reinforcement layers 12 and 20 and first and second thermally and electrically conductive layers 14 and 18 to integrally join first and second structural reinforcement layers 12 and 20 and first and second thermally and electrically conductive layers 14 and 18.

In some examples, rather than first and second thermally and electrically conductive layers 14 and 18 being distinct, separate layers from first and second structural reinforcement layers 12 and 20, the thermally and electrically conductive material may be incorporated within first and second structural reinforcement layers 12 and 20. For example, thermally and electrically conductive wires or filaments may be interwoven with a woven fiber of first and/or second structural reinforcement layers 12 and 20. Further, although the example illustrated in FIG. 1 includes two thermally and electrically conductive layers 14 and 18, in other examples, a composite thermoelectric material may include more or fewer layers of thermally and electrically conductive material.

Fibrous thermoelectric material layer 16 is disposed between and in contact with thermally and electrically conductive layers 14 and 18. Fibrous thermoelectric material layer 16 may include a fibrous thermoelectric material. The fibrous thermoelectric material may include, for example, a thermoelectric polymer or a combination of thermoelectric polymers. The thermoelectric polymer may be an n-type thermoelectric polymer, a p-type thermoelectric polymer, or fibrous thermoelectric material layer 16 may include both an n-type thermoelectric polymer and a p-type thermoelectric polymer. As one specific example, the fibrous thermoelectric material may include a fabric including fibers including poly(3,4-ethylenedioxythiophene):poly(4-styrenesulfonate). The fibers may consist of the thermoelectric polymer, may include a core coated with the thermoelectric polymer, or the like. In some examples, the cross-section of the fibers may be on a scale of nanometers (e.g., between about 1 nanometer and about 1,000 nanometers).

The thermoelectric polymer(s) may be shaped as a fiber or plurality of fibers, and the fibers arranged in a unidirectional fiber layup, a mesh, a weave, a braid, or the like. The unidirectional fiber layup, mesh, weave, braid or the like may include a single thermoelectric polymer, e.g., a single n-type thermoelectric polymer or a single p-type thermoelectric polymer, or may include multiple thermoelectric polymers, e.g., at least one n-type thermoelectric polymer and at least one p-type thermoelectric polymer. In some examples, fibrous thermoelectric material layer 16 may include a plurality of unidirectional fiber layups, meshes, weaves, braids, or combinations thereof. Each unidirectional fiber layup, mesh, weave, or braid may include a single thermoelectric polymer or multiple thermoelectric polymers (either of the same or a different type).

In some examples, the fibrous thermoelectric material is encapsulated in a matrix material. The matrix material may be the same or different as the matrix material for the other layers of composite thermoelectric material 10. In other examples, the fibrous thermoelectric material is not encapsulated in a matrix material or is encapsulated in a different matrix material than the other layers of composite thermoelectric material 10.

By including first and second structural reinforcement layers 12 and 20, thermally and electrically conductive layers 14 and 18, and fibrous thermoelectric material layer 16, composite thermoelectric material 10 may function as a structural material and a heat transfer material. As such, composite thermoelectric material 10 may be used in applications in which both structural strength and heat transfer are desirable, such as electronics enclosures. For example, composite thermoelectric material 10 may be used to define at least one wall of an electronics enclosure (e.g., all walls of the electronics enclosure). First and second structural reinforcement layers 12 and 20 may provide structural strength to the walls of the enclosure to protect electronic components within the electronics enclosure and may transfer heat to and/or from thermally and electrically conductive layers 14 and 18. Thermally and electrically conductive layers 14 and 18 may conduct heat to and/or from fibrous thermoelectric material layer 16 and may provide electrical connects to fibrous thermoelectric material layer 16 to enable the thermoelectric effect upon application of a current to fibrous thermoelectric material layer 16. Fibrous thermoelectric material layer 16 may act as a heat pump to cause heat to flow from one side of fibrous thermoelectric material layer 16 to the other (e.g., from one of thermally and electrically conductive layers 14 and 18 to the other of thermally and electrically conductive layers 14 and 18).

In some examples, a composite thermoelectric material 10 may include a different construction than that shown in FIG. 1. For example, FIG. 2 is a conceptual diagram illustrating another composite thermoelectric material 30 in accordance with the disclosure. Composite thermoelectric material 30 may be similar to or the same as composite thermoelectric material 10 of FIG. 1, aside from the differences described herein.

Like composite thermoelectric material 10, composite thermoelectric material 30 includes a first and second structural reinforcement layers 32 and 40. Composite thermoelectric material 30 also include thermally and electrically conductive layers and fibrous thermoelectric material layers. However, unlike composite thermoelectric material 10, composite thermoelectric material 30 includes multiple domains or regions. In a first region, composite thermoelectric material 30 includes a first thermally and electrically conductive layer 34A, a first fibrous thermoelectric material layer 36A, and a second thermally and electrically conductive layer 38A. In a second region, composite thermoelectric material 30 includes a third thermally and electrically conductive layer 34B, a second fibrous thermoelectric material layer 36B, and a fourth thermally and electrically conductive layer 38B. The first and second regions are separated by material 42.

The first and second regions may be electrically separated from each other by material 42, such that currents may be applied to first thermally and electrically conductive layer 34A, first fibrous thermoelectric material layer 36A, and second thermally and electrically conductive layer 38A independently from third thermally and electrically conductive layer 34B, second fibrous thermoelectric material layer 36B, and fourth thermally and electrically conductive layer 38B. As such, the first region (e.g., first thermally and electrically conductive layer 34A, second thermally and electrically conductive layer 38A, or both) may be electrically coupled to a different current source than the second region (e.g., third thermally and electrically conductive layer 34B, fourth thermally and electrically conductive layer 38B, or both). This allows independent control of heat flow through the first region and the second region. Such independent control may be desirable to allow independent control of cooling of two different components adjacent to the first region and the second region, respectively.

Material 42 may be an electrically insulating material (e.g., a dielectric) to electrically isolate the first region from the second region. In some examples, material 42 may include the matrix material that encapsulates layers of composite thermoelectric material 30.

Although two regions are shown in FIG. 2, composite thermoelectric material 30 may be divided into any number of regions (e.g., generally, a plurality of regions) to allow independent control of heat transfer in any number of regions of thermoelectric composite material 30.

In some examples, a composite thermoelectric material may include additional layers (e.g., more than five layers). For example, FIG. 3 is a conceptual diagram illustrating another composite thermoelectric material 50 in accordance with the disclosure. Composite thermoelectric material 50 may be similar to or the same as composite thermoelectric material 10 of FIG. 1, aside from the differences described herein.

Like composite thermoelectric material 10, composite thermoelectric material 50 includes a first and second structural reinforcement layers 52 and 68. First and second structural reinforcement layers 52 and 68 are the outer layers of composite thermoelectric material 50 and define the outer major surfaces of composite thermoelectric material 50.

Composite thermoelectric material 50 also includes a first thermally and electrically conductive layer 54, a first fibrous thermoelectric material layer 56, a second thermally and electrically conductive layer 58, a second fibrous thermoelectric material layer 60, a third thermally and electrically conductive layer 62, a third fibrous thermoelectric material layer 64, and a fourth thermally and electrically conductive layer 66. Respective thermally and electrically conductive layers interleave or alternate with respective fibrous thermoelectric material layers. Any number of thermally and electrically conductive layers may interleave or alternate with any number of respective fibrous thermoelectric material layers. By including a plurality of thermally and electrically conductive layers interleaved or alternating with respective fibrous thermoelectric material layers, a heat transfer capacity may be increased.

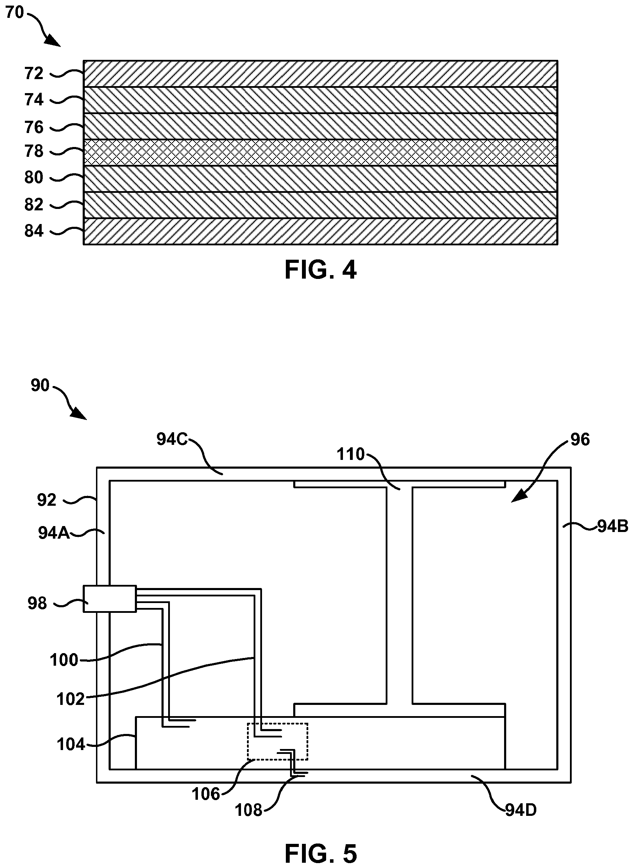

FIG. 4 is a conceptual diagram illustrating another composite thermoelectric material 70 in accordance with the disclosure. Composite thermoelectric material 70 may be similar to or the same as composite thermoelectric material 10 of FIG. 1, aside from the differences described herein.

Like composite thermoelectric material 10, composite thermoelectric material 70 includes a first and second structural reinforcement layers 72 and 84. First and second structural reinforcement layers 72 and 84 are the outer layers of composite thermoelectric material 70 and define the outer major surfaces of composite thermoelectric material 70.

Composite thermoelectric material 70 also includes a first thermally and electrically conductive layer 74, a second thermally and electrically conductive layer 76, a fibrous thermoelectric material layer 78, a third thermally and electrically conductive layer 80, and a fourth thermally and electrically conductive layer 82. First and second thermally and electrically conductive layers 74 and 76 are between first structural reinforcement layer 72 and fibrous thermoelectric material layer 78. Third and fourth thermally and electrically conductive layers 80 and 82 are between fibrous thermoelectric material layer 78 and second structural reinforcement layer 84. Fibrous thermoelectric material layer 78 is between first and second thermally and electrically conductive layers 74 and 76 on one side and third and fourth thermally and electrically conductive layers 80 and 82 on the other side.

By including additional thermally and electrically conductive layers, a current density provided to fibrous thermoelectric material layer 78 may be increased, which may increase cooling and/or heating capacity of composite thermoelectric material 70. Although composite thermoelectric material 70 is illustrated as being symmetrical, with the same number of thermally and electrically conductive layers on either side of fibrous thermoelectric material layer 78, in other examples, more thermally and electrically conductive layers may be provided on one side of fibrous thermoelectric material layer 78 than on the other side of fibrous thermoelectric material layer 78.

Although FIGS. 1-4 illustrate different examples of a composite thermoelectric material, any of the features of composite thermoelectric materials 10, 30, 50, and 70 may be combined in any combination. For example, a composite thermoelectric material may include multiple regions, as shown in FIG. 2, and each of the regions may be selected from the configurations shown in FIGS. 1-4. The configuration of one region may be the same or different from any other region. As another example, the alternating layers concept of FIG. 3 may be combined with the multiple thermally and electrically conductive layers shown in FIG. 4, such that there may be two or more thermally and electrically conductive layers directly adjacent to each other in a thermally and electrically conductive layer set, and the thermally and electrically conductive layer set may be interleaved with or alternating with fibrous thermoelectric material layers. Other combinations will be apparent to those having ordinary skill in the art and are within the scope of this disclosure.

As described above, in some examples, composite thermoelectric materials 10, 30, 50, and 70 may be used to form walls of an enclosure or chassis, such as an electronics enclosure. FIG. 5 is a conceptual diagram illustrating an example electronics enclosure including walls formed from a composite thermoelectric material.

FIG. 5 illustrates an electronics system 90 that includes an electronics enclosure 92 including walls 94A-94D (collectively, "walls 94"). Walls 94 together define an enclosed internal volume 96 within electronics enclosure 92. An electronic component 104 is disposed within internal volume 96 of electronics enclosure 92. Electronics enclosure 92 may define a substantially closed space that separates electronic component 104 from the external environment and protects electronic component 104 from physical damage, the surrounding environmental conditions, or the like.

At least one of walls 94 may include a composite thermoelectric material, such as one or more of composite thermoelectric materials 10, 30, 50, or 70. In some examples, each of walls 94 includes a composite thermoelectric material. The composition of each of walls 94 may be the same, or the composition of one or more of walls 94 may be different than one or more other of walls 94. For example, wall 94D may include a structure and composition like composite thermoelectric material 70 of FIG. 4 while walls 94A-94C include a structure and composition like composite thermoelectric material 10 of FIG. 1. Other combinations will apparent to those having ordinary skill in the art and are within the scope of this disclosure.

One or more of walls 94 may define an aperture that is sized and configured to receive a connector 98. For example, wall 94A defines an aperture that is sized and configured to receive a connector 98. Connector 98 may include electrical connections to allow power and communication connections between electronic component 104 and an external device. In some examples, connector 98 communication connections 100 and power connections 102. Connector 98 may include any suitable number of connections, and the connections may comply with any suitable communications protocol and/or connector standard. Communication connections 100 and power connections 102 connect to electronic component 104.

Electronic component 104 may be any active or passive electronic component. In some examples, electronic component 104 includes a plurality of electronic components, e.g., mounted to a printed board. For example, electronic component 104 may include a processor or processing circuitry such as any one or more of a microprocessor, a controller, a digital signal processor (DSP), an application specific integrated circuit (ASIC), a field-programmable gate array (FPGA), or equivalent discrete or integrated logic circuitry. Electronic component 104 may include processing circuitry 106 configured to control operation of composite thermoelectric material within walls 94. For example, processing circuitry 106 may be configured to receive power via power connections 102 and provide the power as electric current to thermally and electrically conductive layers within walls 94. In some examples, processing circuitry 106 may be coupled to one or more thermal sensors positioned at one or more locations within electronics enclosure 92. The thermal sensor(s) may be configured to measure a temperature of the location(s) at which the thermal sensor(s) is located. For example, a thermal sensor may be located at a location within internal volume 96, a location within electronics component 104 (such as a junction or the like), or the like.

Processing circuitry 106 may be configured to receive a signal indicative of the measured temperature(s) and control operation of the composite thermoelectric material of walls 94 based on the received signal. For example, processing circuity 106 may be configured to control the heat flow through composite thermoelectric material to maintain a temperature of internal volume 96 and/or need to keep electronic component 104 within a predetermined range, such as below about 125°C, such as between about -40°C and about 100°C. Processing circuitry 106 may be configured to control a direction of heat flow (e.g., into internal volume 96 or out of internal volume 96) by controlling a sign of the electrical current applied to walls 94.

In some examples, walls 94 may include multiple regions, as shown in FIG. 2, and processing circuitry 106 may be configured to control respective regions of walls 94 based on respective signals received from respective thermal sensors. Such an arrangement may allow electronics system 90 to include different portions with different heat flow, such as different cooling rates. For example, processing circuitry 106 may control first, second, and third walls 94A-94C to control internal environment 96 at a first rate and control fourth wall 94D to cool electronic component 104 at a second rate greater or less than the first rate.

Electronic component 104 may be thermally coupled to walls 94 directly or indirectly. For example, electronic component 104 may be in direct physical contact with wall 94D. In some examples, a thermal interface material, such as a thermal paste or solder, may be present between electronic component 104 and wall 94D to facilitate heat transfer between electronic component 104 and wall 94D, and vice versa. As another example, electronic component 104 may be thermally coupled to wall 94C via one or more heat exchanger 110, such as a vapor chamber, a heat pipe, or the like.

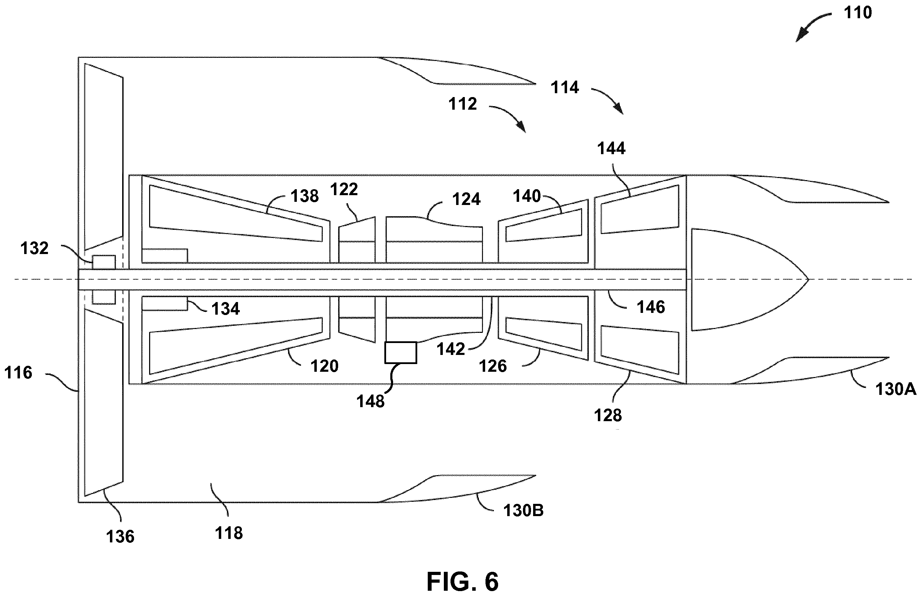

In some examples, electronics system 90 and electronics enclosure 92 may be implemented in a gas turbine engine. FIG. 6 is a conceptual diagram illustrating an example gas turbine engine that includes an electronics enclosure including a composite thermoelectric material. Gas turbine engine 110 may be a main propulsion engine of an aircraft, marine vehicle, or the like. Although described herein as with respect to an aircraft propulsion system, in other examples, gas turbine engine 110 may be part of a propulsion system for providing propulsive thrust to any type of gas turbine engine powered vehicle, as discussed above, configured to provide power to a generator, or configured to provide power any suitable nonvehicle system including gas turbine engine 20.

Engine 110 is a primary propulsion engine that provides thrust for flight operations of the aircraft. In some examples, engine 110 is a two-spool engine having a high pressure (HP) spool 112 and a low pressure (LP) spool 114. In other examples, engine 110 may include three or more spools, e.g., may include an intermediate pressure (IP) spool and/or other spools. In some examples, engine 110 is a turbofan engine, wherein LP spool 114 is operative to drive a propulsor in the form of a turbofan (fan) system 28. In other examples, engine 20 may not include a LP spool or fan system 116. In some examples, engine 110 may include any suitable turbine powered-engine propulsion system, including but not limited to, a turbojet engine or a turboprop engine.

As illustrated in FIG. 6, engine 110 includes a fan system 116 in fluid communication with a bypass duct 118 and a compressor system 120. A diffuser 122 is in fluid communication with compressor system 120. A combustion system 124 is fluidically disposed between compressor system 120 and a high pressure (HP) turbine system 126 (e.g., disposed between compressor system 120 and HP turbine system 126 such that air or another fluid may flow from compressor system 120 to combustion system 124 to HP turbine system 126). In some examples, combustion system 124 includes a combustion liner (not shown) that encloses a continuous combustion process. In other examples, combustion system 124 may take other forms, and may be, for example, a wave rotor combustion system, a rotary valve combustion system, a pulse detonation combustion system, or a slinger combustion system, and may employ deflagration and/or detonation combustion processes. A low pressure (LP) turbine system 128 is fluidically disposed between HP turbine system 38 and a nozzle 130A configured to discharge a core flow of engine 110 (e.g., disposed between HP turbine system 126 and nozzle 130A such that air or another fluid may flow from HP turbine system 126 to LP turbine system 128 to nozzle 130A). A nozzle 130B is in fluid communication with bypass duct 128, and operative to transmit a bypass flow generated by fan system 116 around the core of engine 110. In other examples, other nozzle arrangements may be employed, e.g., a common nozzle for core and bypass flow; a nozzle for core flow, but no nozzle for bypass flow; or another nozzle arrangement.

Fan system 116 includes a fan rotor system 136 having one or more rotors (not shown) that are driven by LP spool 114 of LP turbine system 128. Fan system 116 may include one or more vanes (not shown). Compressor system 120 includes a compressor rotor system 138. In some examples, compressor rotor system 138 includes one or more rotors (not shown) that are powered by HP turbine system 126. High pressure turbine system 126 includes a first turbine rotor system 140. First turbine rotor system 140 includes one or more rotors (not shown) operative to drive compressor rotor system 138. First turbine rotor system 140 is drivingly coupled to compressor rotor system 138 via a shafting system 142. Low pressure turbine system 128 includes a second turbine rotor system 144. Second turbine rotor system 144 includes one or more rotors (not shown) operative to drive fan rotor system 136. Second turbine rotor system 144 is drivingly coupled to fan rotor system 136 via a shafting system 146. Shafting systems 142 and 146 include a plurality of shafts that may rotate at the same or different speeds and directions. In some examples, only a single shaft may be employed in one or both of shafting systems 142 and 146. Turbine system 128 is operative to discharge the engine 110 core flow to nozzle 130A.

During normal operation of gas turbine engine 110, air is drawn into the inlet of fan system 116 and pressurized by fan rotor system 136. Some of the air pressurized by fan rotor system 136 is directed into compressor system 120 as core flow, and some of the pressurized air is directed into bypass duct 128 as bypass flow. Compressor system 120 further pressurizes the portion of the air received therein from fan system 116, which is then discharged into diffuser 122. Diffuser 122 reduces the velocity of the pressurized air, and directs the diffused core airflow into combustion system 124. Fuel is mixed with the pressurized air in combustion system 124, which is then combusted. The hot gases exiting combustion system 124 are directed into turbine systems 126 and 128, which extract energy in the form of mechanical shaft power to drive compressor system 120 and fan system 116 via respective shafting systems 142 and 146.

In some examples, engine 110 may include an electronics enclosure 148. Electronics enclosure 148 may enclose electronics component, such as a full authority digital engine controller (FADEC) or the like. The electronics component may control operation of one or more components of engine 110, overall operation of engine 110, or the like. Electronics enclosure 148 may be similar to or the same as electronics enclosure 92 of FIG. 5. Electronics enclosure 148 may enclose the electronics component and protect the electronics component from the environment of engine 110, e.g., heat, vibration, mechanical shocks, or the like.

Various examples have been described. These and other examples are within the scope of the following claims.

## Claims

1. An electronics enclosure (92) comprising:
a plurality of walls (94), wherein at least one wall of the plurality of walls (94) comprises a fibrous thermoelectric material (16), a thermally and electrically conductive mesh (14, 18), and a matrix material,
a first layer comprising the fibrous thermoelectric material (16), wherein the first layer defines a plane;
a second layer comprising the thermally and electrically conductive mesh (14, 18) electrically coupled to the fibrous thermoelectric material, wherein the second layer is parallel to the plane and configured to facilitate heat transfer between the second layer and the first layer in a direction parallel to the plane; and
the matrix material in which the first layer comprising the fibrous thermoelectric material (16) and the second layer comprising the thermally and electrically conductive mesh (14, 18) are embedded.

2. The electronics enclosure (92) of claim 1, wherein the fibrous thermoelectric material (16) comprises a woven fabric comprising strands.

3. The electronics enclosure (92) of claim 2, wherein the strands comprise a thermoelectric polymer.

4. The electronics enclosure (92) of claim 3, wherein the thermoelectric polymer comprises poly(3,4-ethylenedioxythiophene):poly(styrenesulfonate).

5. The electronics enclosure (92) of any one of claims 2 to 4, wherein the thermally and electrically conductive mesh (14, 18) is interwoven with the strands of the woven fabric.

6. The electronics enclosure (92) of any one of claims 1 to 5, wherein the thermally and electrically conductive mesh (14, 18) comprises a metal or alloy.

7. The electronics enclosure (92) of any one of claims 1 to 6, wherein the matrix material comprises one or more of a polyester, an epoxy, a polyamide, a polycarbonate, a polypropylene, and a vinyl ester.

8. The electronics enclosure (92) of any one of claims 1 to 7, wherein the thermally and electrically conductive mesh is a first thermally and electrically conductive mesh (14), further comprising a second thermally and electrically conductive mesh (18), and wherein the fibrous thermoelectric material (16) is between the first thermally and electrically conductive mesh (14) and the second thermally and electrically conductive mesh (18).

9. The electronics enclosure of any preceding claim, further comprising one or more electrical connectors configured to electrically couple at least one of the one or more electronic components to the thermally and electrically conductive mesh to provide electrical current to the fibrous thermoelectric material

10. The electronics enclosure (92) of any one of claims 1 to 9, wherein the at least one wall comprises a plurality of layers of the fibrous thermoelectric material (56, 60, 64) and a plurality of layers of the thermally and electrically conductive mesh (54, 58, 62, 66), and wherein respective layers of the fibrous thermoelectric material (56, 60, 64) alternate with respective layers of the thermally and electrically conductive mesh (54, 58, 62, 66).

11. The electronics enclosure (92) of any one of claims 1 to 10, further comprising a power connector (98) electrically coupled to the fibrous thermoelectric material (16).

12. The electronics enclosure (92) of any one of claims 1 to 11, further comprising structural reinforcement material (12, 20) embedded in the matrix material.

13. A system (90) comprising:
the electronics enclosure (92) of any one of claims 1 to 12; and
an electronic component (104) enclosed in an internal volume (96) of the electronics enclosure (92), wherein the electronic component (104) is thermally coupled to the electronics enclosure (92).

14. The system (90) of claim 13, further comprising at least one heat pipe positioned to thermally couple the electronic component (104) to the electronics enclosure (92).

15. The system (90) of claim 13, wherein the electronic component (104) is positioned in thermal contact with the electronics enclosure (92).

## Patentansprüche

1. Elektronikgehäuse (92), umfassend:
eine Vielzahl von Wänden (94), wobei mindestens eine Wand der Vielzahl von Wänden (94) ein faseriges thermoelektrisches Material (16), ein thermisch und elektrisch leitendes Geflecht (14, 18) und ein Matrixmaterial umfasst,
eine erste Schicht, die das faserige thermoelektrische Material (16) umfasst, wobei die erste Schicht eine Ebene definiert;
eine zweite Schicht, die das thermisch und elektrisch leitende Geflecht (14, 18) umfasst, das elektrisch mit dem faserigen thermoelektrischen Material verbunden ist, wobei die zweite Schicht parallel zur Ebene liegt und dazu konfiguriert ist, eine Wärmeübertragung zwischen der zweiten Schicht und der ersten Schicht in einer zu der Ebene parallelen Richtung zu erleichtern; und
das Matrixmaterial, in dem die erste Schicht, die das faserige thermoelektrische Material (16) umfasst, und die zweite Schicht, die das thermisch und elektrisch leitende Geflecht (14, 18) umfasst, eingebettet sind.

2. Elektronikgehäuse (92) nach Anspruch 1, wobei das faserige thermoelektrische Material (16) einen gewebten Stoff umfasst, der Stränge umfasst.

3. Elektronikgehäuse (92) nach Anspruch 2, wobei die Stränge ein thermoelektrisches Polymer umfassen.

4. Elektronikgehäuse (92) nach Anspruch 3, wobei das thermoelektrische Polymer Poly(3,4-ethylendioxythiophen):Poly(styrolsulfonat) umfasst.

5. Elektronikgehäuse (92) nach einem der Ansprüche 2 bis 4, wobei das thermisch und elektrisch leitende Geflecht (14, 18) mit den Strängen des gewebten Stoffs verwoben ist.

6. Elektronikgehäuse (92) nach einem der Ansprüche 1 bis 5, wobei das thermisch und elektrisch leitende Geflecht (14, 18) ein Metall oder eine Legierung umfasst.

7. Elektronikgehäuse (92) nach einem der Ansprüche 1 bis 6, wobei das Matrixmaterial eines oder mehrere von einem Polyester, einem Epoxid, einem Polyamid, einem Polycarbonat, einem Polypropylen und einem Vinylester umfasst.

8. Elektronikgehäuse (92) nach einem der Ansprüche 1 bis 7, wobei das thermisch und elektrisch leitende Geflecht ein erstes thermisch und elektrisch leitendes Geflecht (14) ist,
ferner ein zweites thermisch und elektrisch leitendes Geflecht (18) umfassend, und wobei sich das faserige thermoelektrische Material (16) zwischen dem ersten thermisch und elektrisch leitenden Geflecht (14) und dem zweiten thermisch und elektrisch leitenden Geflecht (18) befindet.

9. Elektronikgehäuse nach einem vorhergehenden Anspruch, ferner einen oder mehrere elektrische Verbinder umfassend, die dazu konfiguriert sind, mindestens eine der einen oder mehreren elektronischen Komponenten elektrisch mit dem thermisch und elektrisch leitenden Geflecht zu koppeln, um dem faserigen thermoelektrischen Material elektrischen Strom bereitzustellen.

10. Elektronikgehäuse (92) nach einem der Ansprüche 1 bis 9, wobei die mindestens eine Wand eine Vielzahl von Schichten des faserigen thermoelektrischen Materials (56, 60, 64) und eine Vielzahl von Schichten des thermisch und elektrisch leitenden Geflechtes (54, 58, 62, 66) umfasst und wobei jeweilige Schichten des faserigen thermoelektrischen Materials (56, 60, 64) mit jeweiligen Schichten des thermisch und elektrisch leitenden Geflechtes (54, 58, 62, 66) abwechseln.

11. Elektronikgehäuse (92) nach einem der Ansprüche 1 bis 10, ferner einen Leistungsverbinder (98) umfassend, der elektrisch mit dem faserigen thermoelektrischen Material (16) gekoppelt ist.

12. Elektronikgehäuse (92) nach einem der Ansprüche 1 bis 11, ferner ein strukturelles Verstärkungsmaterial (12, 20) umfassend, das in das Matrixmaterial eingebettet ist.

13. System (90), umfassend:
das Elektronikgehäuse (92) nach einem der Ansprüche 1 bis 12; und
eine elektronische Komponente (104), die in einem Innenvolumen (96) des Elektronikgehäuses (92) eingeschlossen ist, wobei die elektronische Komponente (104) thermisch mit dem Elektronikgehäuse (92) gekoppelt ist.

14. System (90) nach Anspruch 13, ferner mindestens ein Wärmerohr umfassend, das so positioniert ist, dass es die elektronische Komponente (104) thermisch mit dem Elektronikgehäuse (92) koppelt.

15. System (90) nach Anspruch 13, wobei die elektronische Komponente (104) in thermischem Kontakt mit dem Elektronikgehäuse (92) positioniert ist.

## Revendications

1. Boîtier électronique (92) comprenant :
une pluralité de parois (94), dans lequel au moins une paroi de la pluralité de parois (94) comprend un matériau thermoélectrique fibreux (16), un maillage thermiquement et électriquement conducteur (14, 18) et un matériau de matrice,
une première couche comprenant le matériau thermoélectrique fibreux (16), dans lequel la première couche définit un plan ;
une seconde couche comprenant le maillage thermiquement et électriquement conducteur (14, 18) couplé électriquement au matériau thermoélectrique fibreux, dans lequel la seconde couche est parallèle au plan et configurée pour faciliter le transfert de chaleur entre la seconde couche et la première couche dans une direction parallèle au plan ; et le matériau de matrice dans lequel la première couche comprenant le matériau thermoélectrique fibreux (16) et la seconde couche comprenant le maillage thermiquement et électriquement conducteur (14, 18) sont noyées.

2. Boîtier électronique (92) selon la revendication 1, dans lequel le matériau thermoélectrique fibreux (16) comprend un tissu tissé comprenant des brins.

3. Boîtier électronique (92) selon la revendication 2, dans lequel les brins comprennent un polymère thermoélectrique.

4. Boîtier électronique (92) selon la revendication 3, dans lequel le polymère thermoélectrique comprend du poly(3,4-éthylènedioxythiophène):poly(styrènesulfonate).

5. Boîtier électronique (92) selon l'une quelconque des revendications 2 à 4, dans lequel le maillage thermiquement et électriquement conducteur (14, 18) est entrelacé avec les brins du tissu tissé.

6. Boîtier électronique (92) selon l'une quelconque des revendications 1 à 5, dans lequel le maillage thermiquement et électriquement conducteur (14, 18) comprend un métal ou un alliage.

7. Boîtier électronique (92) selon l'une quelconque des revendications 1 à 6, dans lequel le matériau de matrice comprend un ou plusieurs parmi un polyester, un époxy, un polyamide, un polycarbonate, un polypropylène et un ester vinylique.

8. Boîtier électronique (92) selon l'une quelconque des revendications 1 à 7, dans lequel le maillage thermiquement et électriquement conducteur est un premier maillage thermiquement et électriquement conducteur (14), comprenant en outre un second maillage thermiquement et électriquement conducteur (18), et dans lequel le matériau thermoélectrique fibreux (16) se trouve entre le premier maillage thermiquement et électriquement conducteur (14) et le second maillage thermiquement et électriquement conducteur (18).

9. Boîtier électronique selon l'une quelconque des revendications précédentes, comprenant en outre un ou plusieurs connecteurs électriques configurés pour coupler électriquement au moins l'un de l'un ou plusieurs composants électroniques au maillage thermiquement et électriquement conducteur pour fournir un courant électrique au matériau thermoélectrique fibreux.

10. Boîtier électronique (92) selon l'une quelconque des revendications 1 à 9, dans lequel l'au moins une paroi comprend une pluralité de couches du matériau thermoélectrique fibreux (56, 60, 64) et une pluralité de couches du maillage thermiquement et électriquement conducteur (54, 58, 62, 66), et dans lequel les couches respectives du matériau thermoélectrique fibreux (56, 60, 64) alternent avec les couches respectives du maillage thermiquement et électriquement conducteur (54, 58, 62, 66).

11. Boîtier électronique (92) selon l'une quelconque des revendications 1 à 10, comprenant en outre un connecteur d'alimentation (98) couplé électriquement au matériau thermoélectrique fibreux (16).

12. Boîtier électronique (92) selon l'une quelconque des revendications 1 à 11, comprenant en outre un matériau de renforcement structurel (12, 20) intégré dans le matériau de matrice.

13. Système (90) comprenant :
le boîtier électronique (92) selon l'une quelconque des revendications 1 à 12 ; et
un composant électronique (104) enfermé dans un volume interne (96) du boîtier électronique (92), dans lequel le composant électronique (104) est couplé thermiquement au boîtier électronique (92).

14. Système (90) selon la revendication 13, comprenant en outre au moins un caloduc positionné pour coupler thermiquement le composant électronique (104) au boîtier électronique (92).

15. Système (90) selon la revendication 13, dans lequel le composant électronique (104) est positionné en contact thermique avec le boîtier électronique (92).
